(19) Europäisches Patentamt
European Patent Office
Office européen des brevets

(11) **EP 2 959 306 B1**

(12) **EUROPÄISCHE PATENTSCHRIFT**

(45) Veröffentlichungstag und Bekanntmachung des Hinweises auf die Patenterteilung:
**21.12.2016 Patentblatt 2016/51**

(21) Anmeldenummer: **14702227.1**

(22) Anmeldetag: **28.01.2014**

(51) Int Cl.:
**G01R 35/00** (2006.01)     **G01R 19/02** (2006.01)
**G01R 21/10** (2006.01)     **G06G 7/20** (2006.01)

(86) Internationale Anmeldenummer:
**PCT/EP2014/051616**

(87) Internationale Veröffentlichungsnummer:
**WO 2014/127960 (28.08.2014 Gazette 2014/35)**

(54) **LEISTUNGSMESSGERÄT MIT INTERNER KALIBRIERUNG VON DIODENDETEKTOREN**

POWER MEASURING INSTRUMENT WITH INTERNAL CALIBRATION OF DIODE DETECTORS

APPAREIL DE MESURE DE PUISSANCE À ÉTALONNAGE INTERNE DE DÉTECTEURS À DIODES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.02.2013 DE 102013202903**

(43) Veröffentlichungstag der Anmeldung:
**30.12.2015 Patentblatt 2015/53**

(73) Patentinhaber: **Rohde & Schwarz GmbH & Co. KG 81671 München (DE)**

(72) Erfinder:
• **BRATFISCH, Toralf**
**85640 Putzbrunn (DE)**
• **KATZER, Michael**
**80337 München (DE)**
• **REICHEL, Thomas**
**77839 Lichtenau (DE)**

(74) Vertreter: **Körfer, Thomas**
**Mitscherlich PartmbB**
**Patent- und Rechtsanwälte**
**Sonnenstrasse 33**
**80331 München (DE)**

(56) Entgegenhaltungen:
**EP-A1- 1 043 595         EP-A1- 1 443 335**
**DE-A1-102006 024 699   US-A- 3 710 253**
**US-A- 4 873 484           US-A- 5 204 613**
**US-A1- 2012 235 733     US-B1- 6 397 160**
**US-B1- 6 407 540**

EP 2 959 306 B1

**Beschreibung**

Die Erfindung betrifft ein Leistungsmessgerät, welches Diodendetektoren einsetzt.

Messköpfe zur Hochfrequenz (HF)-Leistungsmessung arbeiten entweder thermisch oder verwenden Diodendetektoren, beispielsweise auf der Basis von Zero-Bias-Schottky-Dioden oder Dioden in 'Planar Doped Barrier Technologie'. Dioden zur Hochfrequenz-Gleichrichtung werden auf ein günstiges HF-Verhalten, wie z.B. eine kleine Sperrschichtkapazität, optimiert. Dies geht jedoch zu Lasten der Robustheit. Durch bereits sehr kurzzeitige Überschreitung der Maximalleistung oder elektrostatische Entladungen können diese hochempfindlichen Bauelemente irreversibel beschädigt werden. Dies ist nicht immer offensichtlich. Es muss nicht stets ein Totalausfall vorliegen. In vielen Fällen kann noch ein plausibles Messergebnis angezeigt werden, obwohl die zulässigen Messabweichungen bereits überschritten sind.

Aus diesem Grund ist es üblich, HF-Leistungsmessköpfe regelmäßig an einer externen Kalibrierquelle zu testen oder daran abzugleichen. Dieses Verfahren ist jedoch nachteilig, da der Messkopf manuell an die Kalibrierquelle angeschlossen werden muss. Insbesondere bei einem Messaufbau in der Fertigung müsste der Messkopf aus dem Aufbau ausgebaut werden. Dies ist für einen reibungslosen Fertigungsablauf nicht wünschenswert. Hinzu kommt, dass beim Einsatz von USB-Leistungsmessköpfen derartige externe Kalibrierquellen nicht zuverlässig zur Verfügung stehen.

Zur Durchführung der Messung ist mit einem derartigen Messkopf lediglich ein handelsüblicher PC notwendig.

So zeigt die europäische Patentanmeldung EP 1 443 335 A1 ein Leistungsmessgerät mit interner Kalibrierung. Dabei wird eine Strom-Spannungs-Kennlinie der Detektordiode vermessen. Dazu wird eine bekannte, in ihrer Höhe variable Referenzspannung mit Hilfe des Messverstärkers an die Detektordiode angelegt und der resultierende Strom gemessen. Diese Überprüfung der Funktionsfähigkeit der Detektor-Diode funktioniert jedoch nur, wenn der Messverstärker in invertierender Konfiguration betrieben wird, d.h. einen niederohmigen Eingang aufweist. Dies ist häufig der Fall bei Breitbandmessköpfen, wo nicht die Leerlauf-Ausgangsspannung, sondern der Kurzschluss-Ausgangsstrom des Diodendetektors gemessen wird, um die durch die Anwendung geforderten kleinen Abfallzeiten im Bereich weniger Nanosekunden realisieren zu können. Breitbandmessköpfe werden, vergleichbar mit einem Oszilloskop, vorzugsweise zum Messen der Hüllkurve, d.h. der zeitveränderlichen Amplitude gepulster und/oder modulierter hochfrequenter Messsignale verwendet. Bei Messköpfen zum Messen der mittleren Leistung, welche den Detektor im quadratischen Bereich der Gleichrichterdioden betreiben, hat der Messverstärker jedoch eine nicht invertierende Konfiguration. Das ist erforderlich, um das transformierte Messsignal, die Leerlauf-Ausgangsspannung des Diodendetektors, möglichst unverfälscht messen zu können. Die von der europäischen Patentanmeldung gezeigte Kalibrierung ist bei derartigen Messköpfen somit nicht anwendbar. Darüber hinaus lässt sich mit der dort gezeigten Kalibrierung die Gleichrichtwirkung des Detektors im quadratischen Bereich nicht auf einem ausreichend hohen Genauigkeitsniveau beurteilen.

Die deutsche Offenlegungsschrift DE 10 2006 024 699 A1 offenbart zur Messung des Leistungsmittelwerts eines Hochfrequenzsignals eine Vorrichtung mit antiparallel geschalteten Dioden als Detektorelemente und mit einem gegengekoppelten Verstärker. Weiterhin offenbart die europäische Patentanmeldung EP 1 043 595 A1 eine Kalibrationseinrichtung, welche einen Kalibrationsstrom am Signaleingang anlegt.

Der Erfindung liegt die Aufgabe zugrunde, ein Leistungsmessgerät zum Messen der mittleren Leistung zu schaffen, welches ohne weitere externe Geräte eine hochgenaue Kalibrierung ermöglicht.

Die Aufgabe wird erfindungsgemäß durch die Merkmale des unabhängigen Anspruchs 1 gelöst. Vorteilhafte Weiterbildungen sind Gegenstand der derart rückbezogenen Unteransprüche.

Das erfindungsgemäße Messgerät zur Messung einer Leistung eines Messsignals verfügt über eine Analog-Verarbeitungseinrichtung und eine Kalibrier-Einrichtung zur Durchführung eines Kalibriervorgangs. Die Analog-Verarbeitungseinrichtung weist zwei gegenüber einem Signaleingang antiparallel geschaltete Detektordioden und einen Verstärker zur Verstärkung von Signalen, welche von Ausgangssignalen der Detektordioden abgeleitet sind, auf. Die Analog-Verarbeitungseinrichtung weist weiterhin eine Chopper-Einrichtung auf, welche an zwei Anschlüssen in Serie zwischen die Detektordioden und den Verstärker geschaltet ist. Die Kalibrier-Einrichtung beinhaltet dabei zumindest eine Stromquelle, wobei die zumindest eine Stromquelle mit zumindest einem Eingangsanschluss des Verstärkers verbunden ist. So ist es möglich eine genaue Kalibrierung durchzuführen.

Bevorzugt ist die Stromquelle ausgebildet, um einen Kalibrier-Strom durch die Chopper-Einrichtung und die Detektordioden zu treiben. Der Verstärker ist dann ausgebildet, um eine resultierende Kalibrier-Spannung zu verstärken. Das Messgerät ist dann ausgebildet, um die verstärkte Kalibrier-Spannung zu messen.

Die Chopper-Einrichtung ist bevorzugt ausgebildet, um die Flussrichtung des Kalibrier-Stroms durch die Detektordioden umzupolen und störende Einflüsse des Verstärkers zu eliminieren. Der Verstärker ist dann ausgebildet, um resultierende Kalibrier-Spannungen zu verstärken. Das Messgerät ist in diesem Fall ausgebildet, um die verstärkten Kalibrier-Spannungen zu messen, ohne dass diese durch Gleichspannungs-Offsets verfälscht werden.

Wenn kein Strom von der zumindest einen Stromquelle erzeugt wird, liegt an dem Verstärker bevorzugt ein transformiertes Messsignal oder eine Nullpunkt-Spannung an. Als transformiertes Messsignal soll das Ausgangssignal des Detektors als Reaktion auf ein hochfrequentes Messsignal am Eingang des Detektors verstanden werden. Die Nullpunkt-Spannung soll das Ausgangssignal des Detektors darstellen, wenn kein hochfrequentes Eingangssignal außer dem thermischen Grundrauschen vorhanden ist. Der Verstärker ist dann ausgebildet, um das transformierte Messsignal oder die Nullpunkt-Spannung zu verstärken. Das Messgerät ist dann ausgebildet, um das transformierte Messsignal oder die Nullpunkt-Spannung zu messen. Wenn die gemessene Nullpunktspannung von dem Messwert des transformierten Messsignals subtrahiert wird, kann ein korrigiertes Messergebnis erhalten werden. Das Ergebnis der Nullpunktmessung wird aber auch für die interne Kalibrierung mit der zumindest einen Stromquelle genutzt. Die zumindest eine Stromquelle weist bevorzugt zumindest eine Spannungsquelle und zumindest einen Innenwiderstand auf.

Der zumindest eine Innenwiderstand ist vorteilhafterweise größer als der Ausgangswiderstand des Detektors, bevorzugt zumindest 5 mal größer, besonders bevorzugt zumindest 10 mal größer. Besonders bevorzugt handelt es sich um eine Konstantstromquelle. Dann ist der Innenwiderstand zumindest 1000 mal größer, bevorzugt 10000 mal größer. So wird erreicht, dass der abgegebene Strom möglichst unabhängig vom Ausgangswiderstand des Detektors ist und die ohmsche Belastung des Detektor-Ausgangs klein bleibt. Einerseits ist die ohmsche Belastung durch die Messwiderstände auch bei abgeschalteten Stromquellen gegeben, und andererseits sollte der Detektor idealerweise im Leerlauf betrieben werden, um eine möglichst große Ausgangsspannung und einen niedrigen Temperaturkoeffizienten des Detektors zu erreichen.

Die zumindest eine Stromquelle weist bevorzugt zumindest einen Schalter auf, welcher ausgebildet ist, um den Innenwiderstand von der Spannungsquelle zu trennen und mit einem Masseanschluss zu verbinden. So können definierte Schaltungszustände erreicht werden und Leckströme des Schalters werden nach Masse abgeleitet und fließen nicht in den Detektorausgang.

Bevorzugt weist das Messgerät weiterhin eine Steuereinrichtung auf, welche ausgebildet ist, um die Analog-Verarbeitungseinrichtung und die Kalibrier-Einrichtung zu steuern und um Messergebnisse eines Kalibriervorgangs zu verarbeiten. So ist eine einfache Bedienung möglich.

Die Steuereinrichtung ist vorteilhafterweise ausgebildet, um ein Umschalten der Chopper-Einrichtung und ein Umschalten der Schalter der Kalibrier-Einrichtung zu steuern. So können eine hohe Messgenauigkeit und eine hohe Kalibriergenauigkeit erreicht werden.

Bevorzugt ist die Kalibrier-Einrichtung ausgebildet, um den Kalibriervorgang durchzuführen, während ein Messsignal anliegt. In diesem Fall ist die Steuereinrichtung ausgebildet, um Messergebnisse des Kalibriervorgangs lediglich dann zu berücksichtigen, wenn das Messsignal vorbestimmten Bedingungen genügt. Bevorzugt werden die Messergebnisse des Kalibriervorgangs lediglich dann berücksichtigt, wenn ein Messsignal eine derartige Leistung aufweist, dass die Detektordioden im quadratischen Kennlinienbereich betrieben sind und/oder das Messsignal über einen vorbestimmten Zeitraum konstant ist. So wird erreicht, dass das Messsignal die Kalibrierung nicht beeinflusst.

Die Kalibrier-Einrichtung ist alternativ ausgebildet, um den Kalibriervorgang lediglich durchzuführen, wenn kein Messsignal anliegt. So wird eine störungsfreie Kalibrierung stets sichergestellt.

Die Analog-Verarbeitungseinrichtung ist dabei bevorzugt weitgehend symmetrisch aufgebaut. Weiterhin ist die Kalibrier-Einrichtung bevorzugt weitgehend symmetrisch aufgebaut. So wird erreicht, dass sich Störgrößen weitgehend kompensieren.

Die Kalibrier-Einrichtung weist bevorzugt zwei Stromquellen auf. Die zwei Stromquellen verfügen dann jeweils über eine Spannungsquelle und einen Innenwiderstand. Die zwei Stromquellen sind dann gegensinnig gepolt und mit den beiden Anschlüssen des Verstärkers. So wird ein symmetrischer Aufbau möglich.

Das Messgerät beinhaltet weiterhin bevorzugt eine Temperatur-Messeinrichtung, welche ausgebildet ist, um bei der Durchführung des Kalibriervorgangs die Temperatur zu messen. Das Messgerät ist dann ausgebildet, um die gemessene gegenwärtige Temperatur zu einer Temperaturkompensation des Kalibriervorgangs heranzuziehen. So wird eine besonders genaue Kalibrierung erreicht.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:

Fig. 1 ein Blockschaltbild eines Ausführungsbeispiels des erfindungsgemäßen Messgeräts in einer Übersichtsdarstellung;

Fig. 2a eine erste Detailansicht des Ausführungsbeispiels des erfindungsgemäßen Messgeräts;

Fig. 2b eine zweite Detailansicht des Ausführungsbeispiels des erfindungsgemäßen Messgeräts und

Fig. 2c eine dritte Detailansicht des Ausführungsbeispiels des erfindungsgemäßen Messgeräts.

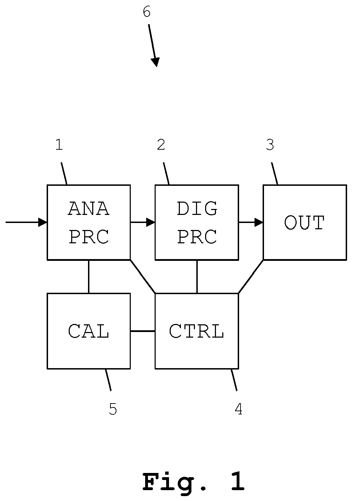

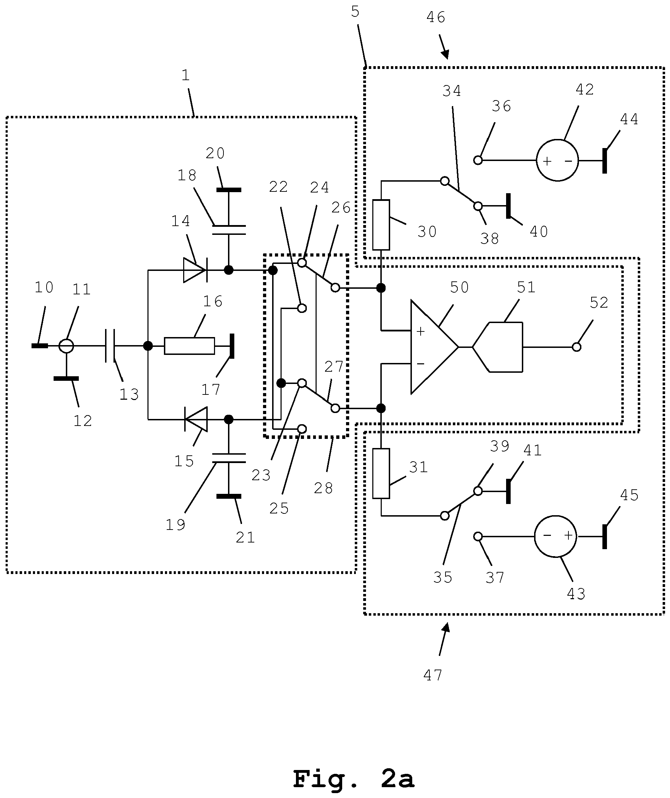

Zunächst wird anhand der Fig. 1 der generelle Aufbau und die generelle Funktionsweise eines Ausführungsbeispiels des erfindungsgemäßen Messgeräts erläutert. Anhand von Fig. 2a - Fig. 2c wird anschließend im Detail auf den Aufbau erfindungswesentlicher Bestandteile des Ausführungsbeispiels des erfindungsgemäßen Messgeräts und seiner Funktion eingegangen. Identische Elemente werden in ähnlichen Abbildungen zum Teil nicht wiederholt dargestellt und beschrieben.

In Fig. 1 ist ein Ausführungsbeispiel des erfindungsgemäßen Messgeräts 6 dargestellt. Das Messgerät 6 verfügt über eine Analog-Verarbeitungseinrichtung 1, mit dieser verbunden eine Digital-Verarbeitungseinrichtung 2 und mit dieser verbunden eine Messwertausgabe-Einrichtung 3. Darüber hinaus verfügt es über eine Kalibrier-Einrichtung 5, welche ebenfalls mit der Analog-Verarbeitungseinrichtung 1 verbunden ist. Weiterhin verfügt das Messgerät über eine Steuereinrichtung 4, welche mit der Analog-Verarbeitungseinrichtung 1, der Digital-Verarbeitungseinrichtung 2, der Messwertausgabe-Einrichtung 3 und der Kalibrier-Einrichtung 5 verbunden ist.

Im Messbetrieb wird ein Messsignal der Analog-Verarbeitungseinrichtung 1 zugeführt. Die Analog-Verarbeitungseinrichtung 1 wandelt das Messsignal in ein analoges Signal, ein transformiertes Messsignalum, welches Rückschlüsse auf die Leistung des Messsignals zulässt. Dieses analoge Signal wird in ein digitales Signal umgewandelt und der Digital-Verarbeitungseinrichtung 2 zugeführt. Die Digital-Verarbeitungseinrichtung 2 bestimmt ausgehend von dem digitalisierten Signal eine Leistung des Messsignals. Diese wird der Messwertausgabe-Einrichtung 3 zur Verfügung gestellt. Die Funktion der Analog-Verarbeitungseinrichtung 1, der Digital-Verarbeitungseinrichtung 2 und der Messwertausgabe-Einrichtung 3 wird dabei von der Steuereinrichtung 4 gesteuert. Auf den detaillierten Aufbau der genannten Einrichtungen wird anhand von Fig. 2a - 2c näher eingegangen.

Um eine Kalibrierung durchzuführen, steuert die Steuereinrichtung 4 die Kalibrier-Einrichtung 5, die Analog-Verarbeitungseinrichtung 1, die Digital-Verarbeitungseinrichtung 2 und die Messwertausgabe-Einrichtung 3 entsprechend an. Insbesondere veranlasst sie die Kalibrier-Einrichtung 5, einen Kalibrier-Strom durch die Analog-Verarbeitungseinrichtung 1 zu treiben. Die Steuereinrichtung 4 steuert die Analog-Verarbeitungseinrichtung 1 dann insbesondere an, um eine resultierende Kalibrier-Spannung zu messen. Auf den genauen Ablauf wird anhand von Fig. 2a - 2c näher eingegangen.

In Fig. 2a ist das erste Ausführungsbeispiel des erfindungsgemäßen Messgeräts 6 in einer Detailansicht dargestellt. Hier dargestellt sind lediglich die Analog-Verarbeitungseinrichtung 1 und die Kalibrier-Einrichtung 5.

Die Analog-Verarbeitungseinrichtung 1 beinhaltet einen Signaleingang 10, welcher zur Einspeisung eines Messsignals ausgebildet ist. Darüber hinaus beinhaltet sie einen Masse-Eingang 11, an welchen eine Schirmung eines Anschlusskabels, welches das Messsignal trägt, angeschlossen werden kann. Der Masseeingang 11 ist mit einem internen Masse-Anschluss 12 verbunden. Der Signaleingang 10 ist mit einem Koppelkondensator 13 verbunden. An seinem abgewandten Anschluss ist der Kondensator 13 wiederum mit einer ersten Detektordiode 14, einem Widerstand 16 und einer zweiten Detektordiode 15 verbunden. Die Detektordioden 14 und 15 sind dabei antiparallel verschaltet. D. h. aus Sicht des Kondensators 13 ist die erste Detektordiode 14 in Flussrichtung geschaltet, während die zweite Detektordiode 15 entgegen Flussrichtung geschaltet ist. Anders ausgedrückt, ist die Anode der ersten Diode 14 mit dem Kondensator 13 und/oder dem Widerstand 16 verbunden, während die Kathode der zweiten Diode 15 mit dem Kondensator 13 und/oder dem Widerstand 16 verbunden ist.

Der Widerstand 16, welcher als Absorber für das auf den Signaleingang 10 auftreffende Messsignal wirkt, ist an seinem abgewandten Ende mit einem Masseanschluss 17 verbunden. Der dem Kondensator 13 abgewandte Anschluss der ersten Detektordiode 14, hier die Katode, ist mit einem gegen einen Masseanschluss 20 geschalteten Kondensator 18 verbunden. Der dem Kondensator 13 abgewandte Anschluss der Detektordiode 15, hier die Anode, ist ebenfalls mittels eines Kondensators 19 mit einem Masseanschluss 21 verbunden.

Weiterhin ist der dem Kondensator 13 abgewandter Anschluss der ersten Detektordiode 14 mit einem ersten Anschluss einer Chopper-Einrichtung 28 verbunden. Der dem Kondensator 13 abgewandte Anschluss der zweiten Detektordiode 15 ist mit einem zweiten Anschluss der Chopper-Einrichtung 28 verbunden.

Die Chopper-Einrichtung 28 beinhaltet dabei einen ersten Schalter 26 und einen zweiten Schalter 27. Der erste Schalter 26 dient dabei zur Umschaltung zwischen einem ersten Anschluss 22 und einem zweiten Anschluss 24. Der zweite Schalter 27 dient dabei einer Umschaltung zwischen einem ersten Anschluss 23 und einem zweiten Anschluss 25. Die Anschlüsse 24 und 25 sind dabei miteinander und mit dem dem Kondensator 13 abgewandten Anschluss der ersten Detektordiode 14 verbunden. Die Anschlüsse 22 und 23 sind dabei miteinander und mit dem dem Kondensator 13 abgewandten Anschluss der zweiten Detektordiode 15 verbunden.

Die Schalter 26 und 27 der Chopper-Einrichtung 28 sind dabei derart ausgebildet, dass sie stets gleichzeitig schalten. D.h. gleichzeitig sind stets die Anschlüsse 23 und 24 bzw. 22 und 25 beschaltet. Die Chopper-Einrichtung 28 erfüllt dabei die Funktion, die Signale der Detektordioden 14, 15 umzupolen. D.h. in einer ersten Schalterstellung (z.B. Anschlüsse 23, 24 aktiv) wird das Ausgangssignal der Detektordioden 14, 15 in umgekehrter Polarität gegenüber einer zweiten Schalterstellung (z.B. Anschlüsse 22, 25 aktiv) zum nachfolgenden Verstärker 50 übertragen.

Der erste Schalter 26 der Chopper-Einrichtung 28 ist dabei mit einem positiven Eingangsanschluss eines Verstärkers 50 verbunden. Der zweite Schalter 27 der Chopper-Einrichtung 28 ist dabei mit einem negativen Eingang des Verstärkers 50 verbunden. Der Verstärker 50 ist dabei derart beschaltet, dass er die Spannung zwischen seinen beiden Eingängen verstärkt und gleichzeitig die Impedanzen zwischen seinen beiden Eingängen einerseits und zwischen den jeweils beiden Eingängen und den Schaltungsmassen 12, 20, 21, 40, 41, 44, 45 andererseits so groß sind, dass die Ausgangsspannungen des Detektors durch diese ohmsche Belastung nicht oder vernachlässigbar gering beeinflusst werden. In der Regel wird dies durch einen Verstärker 50 in nicht-invertierender Konfiguration erreicht. Ein Ausgangsanschluss des Verstärkers 50 ist mit einem Analog-Digital-Wandler 51 verbunden, welcher wiederum mit einem Signal-Ausgang 52 der Analog-Verarbeitungseinrichtung 1 verbunden ist.

Um eine Messung durchzuführen, wird ein Messsignal an dem Eingangs-Anschluss 10 zugeführt. Gleichspannungskomponenten des Messsignals werden mittels des Kondensators 13 entfernt. Die Detektordioden 14, 15 setzen das Messsignal in ein Signal um, welches auf die Leistung des Messsignals schließen lässt. Die Detektordioden 14, 15 werden dabei vorzugsweise im quadratischen Kennlinienbereich betrieben. Über die Kondensatoren 18, 19 und die entsprechenden Masseanschlüsse 20, 21 wird eine Entkopplung des Ausgangssignals des Detektors vom hochfrequenten Messsignal erreicht, indem diese Kondensatoren die dem Kondensator 13 abgewandten Anschlüsse der Detektordioden 14 und 15 hochfrequenzmäßig mit Masse verbinden, während sie gleichzeitig dafür sorgen, dass sich in Folge der Gleichrichtung des Messsignals zwei dazu äquivalente Ausgangsspannungen ausbilden können.

Die Chopper-Einrichtung 28 polt die Ausgangssignale der Detektordioden 14, 15 regelmäßig um, um evtl. vorhandene Unterschiede zwischen den Detektordioden 14, 15 im Ausgangssignal zu kompensieren, und um den Einfluss von Störgrößen zu minimieren. Störgrößen sind vor allem Leckströme und Offsetspannungen des Verstärkers 50. Die Ausgangssignale der Chopper-Einrichtung 28 werden von dem Verstärker 50 verstärkt und von dem Analog-Digital-Wandler in ein digitales Ausgangssignal umgesetzt, welches in einem nachfolgenden Schritt der Digital-Verarbeitungseinrichtung 2 aus Fig. 1 zur digitalen Weiterverarbeitung zugeführt wird. Auf den weiteren Ablauf der Messung wird hier nicht eingegangen, da er für die gegenwärtige Erfindung nicht einschlägig ist.

Mit den Eingangsanschlüssen des Verstärkers 50 sind weiterhin jeweils Stromquellen 46, 47 verbunden. Mit dem positiven Eingangsanschluss des Verstärkers 50 ist eine erste Stromquelle 46 verbunden. Mit dem negativen Eingangsanschluss des Verstärkers 50 ist eine zweite Stromquelle 47 verbunden. Die Stromquellen 46, 47 verfügen jeweils über einen Innenwiderstand 30, 31, welcher jeweils mit dem jeweiligen Eingangsanschluss des Verstärkers 50 verbunden ist. Alternativ können die beiden Stromquellen 46, 47 durch eine gemeinsame Stromquelle ersetzt werden. In diesem Fall ist jeweils ein Anschluss der gemeinsamen Stromquelle mit jeweils einem Eingangsanschluss des Verstärkers 50 verbunden.

Die Innenwiderstände 30, 31 weisen bevorzugt die gleiche Größe auf. Die Werte der Innenwiderstände 30, 31 werden dabei bevorzugt größer als die Nullpunkt-Widerstände der Detektordioden 14, 15 gewählt. Beispielsweise wird ein Wert von 10 MΩ bei einem typischen Dioden-NullpunktWiderstand von 10 kΩ eingesetzt. Es handelt sich dabei um ohmsche Widerstände.

Die Innenwiderstände 30, 31 dürfen dabei nicht zu klein gewählt werden, damit die gemessene Kalibrierspannung infolge der Spannungsteilung nicht unnötig verkleinert wird. Weiterhin sollten sie derart gewählt werden, dass eine resultierende Stromstärke so groß ist, dass ein mittlerer Spannungsabfall $V_0$ vorzugsweise so groß ist, dass der Detektor einerseits möglichst weit ausgesteuert wird, aber der quadratische Kennlinienteil möglichst noch nicht verlassen wird. Eine feste Grenze des quadratischen Kennlinienbereichs existiert dabei jedoch nicht. Üblicherweise wird sie bei $V_0$ = mnuT gesehen.

Mit den jeweils abgewandten Anschlüssen der Innenwiderstände 30, 31 sind Schalter 34, 35 verbunden, welche jeweils zwischen zwei Anschlüssen 36, 37 bzw. 38, 39 umschalten. Jeweils ein erster Anschluss 36, 37 ist bei beiden Stromquellen 46, 47 mit einer Spannungsquelle 42, 43 verbunden, welche wiederum mit einem Masseanschluss 44, 45 verbunden ist. Jeweils ein zweiter Anschluss 38, 39 ist mit einem Masseanschluss 40, 41 verbunden.

Soll nun eine Kalibrierung durchgeführt werden, so wird zunächst eine Nullpunkt-Spannung durch den Verstärker 50 verstärkt und von dem Analog-Digital-Wandler 51 in eine digitale Nullpunkt-Spannung umgesetzt. Dabei wird die Nullpunkt-Spannung als Ausgangssignal der Detektordioden 14, 15 nacheinander bei den beiden unterschiedlichen Schalterstellungen der Chopper-Einrichtung 28 gemessen, ohne dass ein Kalibrierstrom anliegt. Sofern gerade keine Messung durchgeführt wird, wird die Nullpunkt-Spannung von keinem Messsignal beeinflusst. Wird jedoch alternativ gerade eine Messung durchgeführt, so wird die Nullpunkt-Spannung von dem Messsignal beeinflusst. Die gemessene Nullpunkt-Spannung ist jedoch für die Kalibrierung verwendbar, wenn das Messsignal während der gesamten Kalibrierung konstant ist und ausreichend klein ist, damit die Detektordioden 14, 15 im quadratischen Bereich betrieben werden.

Sofern das Messsignal diesen Bedingungen genügt, so wird das Messsignal lediglich als zusätzliche Verschiebung des Nullpunkts der Kalibrier-Messung und damit als additive Nullpunkt-Spannung gemessen.

Die Messung der Nullpunkt-Spannung ist in Fig. 2a gezeigt. Dabei ist dort lediglich eine erste Schalterstellung der Chopper-Einrichtung 28 gezeigt. Selbstverständliche wird die Nullpunktspannung für beide Schalterstellungen der Chopper-Einrichtung 28 gemessen. D.h. die Spannungsquellen 42, 43 sind mittels der Schalter 34, 35 von den Innenwiderständen 30, 31 und damit von den Eingangsanschlüssen des Verstärkers 50 und von der Chopper-Einrichtung 28 getrennt.

Die Nullmessung hat den Zweck, den Einfluss eines eventuell anliegenden Messsignals aus den Kalibriergrößen V0 und ΔV sowie den Einfluss der Offsetspannung des Verstärkers 50 aus der Kalibriergröße V0 zu entfernen (Gl. 8). Da sich beide Störgrößen - die Nullpunkt-Ausgangsspannung des Detektors und die Offsetspannung des Verstärkers - in der einen Chopper-Einstellung zueinander addieren, in der anderen aber voneinander subtrahieren, ist es mit einer einzigen Nullmessung nicht möglich, beide Größen aus dem Kalibrierergebnis zu eliminieren.

Wenn stattdessen für jede der beiden Chopper-Einstellungen eine Nullpunktmessung durchgeführt wird und diese Nullpunkt-Messergebnisse von den Messergebnissen für die Kalibrierspannung in den jeweils identischen Chopper-Einstellungen subtrahiert werden, fallen beide Einflussgrößen aus den Kalibriergrößen V0 und DV heraus.

Der Einfluss der Verstärker-Offsetspannung fällt in der Kalibriergröße ΔV auch ohne zweite Nullmessung heraus, und zwar allein durch die Differenzbildung der beiden Kalibrierspannungen.

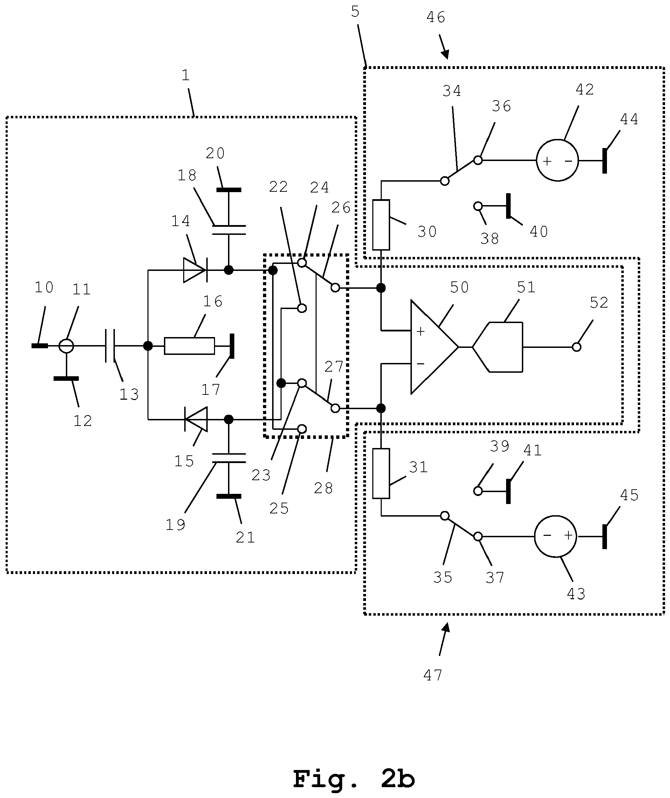

Nachdem die Nullpunkt-Spannung gemessen wurde, wird die Schalterstellung der Schalter 34, 35 verändert. Dies ist in Fig. 2b gezeigt. Die Anschlüsse 36, 37 werden nun über die Innenwiderstände 30, 31 mit den Eingangsanschlüssen des Verstärkers 50 verbunden. Die Spannungsquellen 42, 43 erzeugen nun jeweils eine gegensinnige aber gleichwertige Konstant-Spannung und übertragen sie über die Schalter 34, 35 an die Innenwiderstände 30, 31, welche sie jeweils in einen Konstant-Strom umsetzen und diesen über die Chopper-Einrichtung 28, d.h. über die Schalter 26, 27 an die Anschlüsse 24, 23 übertragen. Der positive Anschluss der Spannungsquelle 42 wird somit mit dem Anschluss 24 der Chopper-Einrichtung verbunden, während der negative Anschluss der Spannungsquelle 43 mit dem Anschluss 23 der Chopper-Einrichtung 28 verbunden wird. Es ergibt sich somit ein Stromfluss von der Spannungsquelle 42 über den Anschluss 24 der Chopper-Einrichtung 28 über die Detektordiode 14, über die Detektordiode 15, über den Anschluss 23 der Chopper-Einrichtung 28 zu dem negativen Anschluss der Spannungsquelle 43.

Dabei ergibt sich ein Konstantstrom, da die Widerstände 30, 31 groß gegenüber den Innenwiderständen der Detektordioden 14, 15 und groß gegenüber den Bahnwiderständen auf einem Strompfad sind. Bevorzugt sind die Innenwiderstände zumindest fünfmal, besonders bevorzugt zumindest zehnmal so groß wie sämtliche übrigen Widerstände in dem Strompfad.

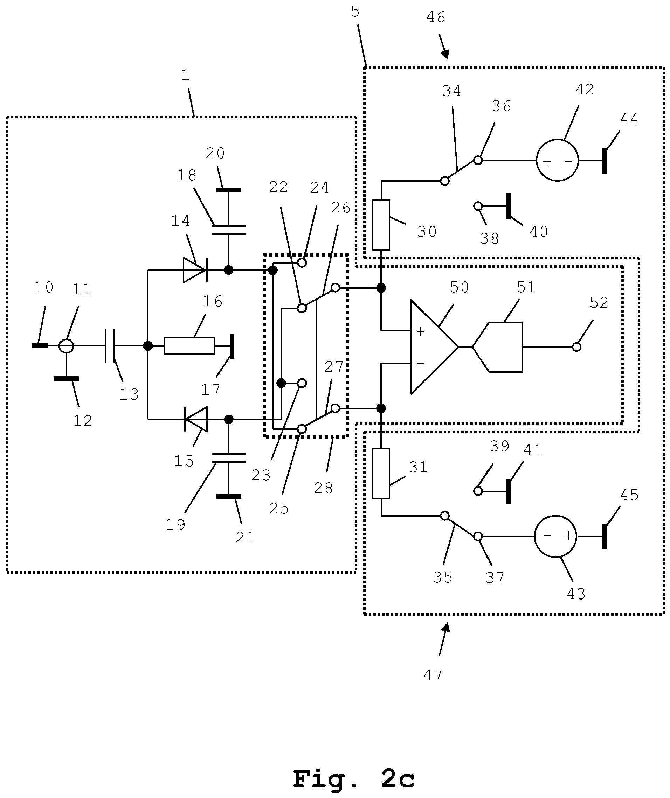

Eine resultierende Spannung an den Anschlüssen des Verstärkers 50 wird durch den Verstärker 50 verstärkt und von dem Analog-Digital-Wandler 51 digitalisiert. Sobald dieser Messwert erfasst ist, wird die Schalterstellung der Chopper-Einrichtung 28 verändert. Dies ist in Fig. 2c dargestellt. Die Schalter 26, 27 verbinden nun die Eingangsanschlüsse des Verstärkers 50 mit den Anschlüssen 22, 25 der Chopper-Einrichtung. Somit ergibt sich ein Stromfluss von dem positiven Anschluss der Spannungsquelle 42 über den Schalter 34, über den Innenwiderstand 30, über den Schalter 26 der Chopper-Einrichtung 28, über den Anschluss 22 der Chopper-Einrichtung über die Detektordiode 15, über die Detektordiode 14, über den Anschluss 25 der Chopper-Einrichtung, über den Schalter 27 der Chopper-Einrichtung, über den Innenwiderstand 31, über den Schalter 35 zu dem negativen Anschluss der Spannungsquelle 43.

Auch hier wird die Spannung zwischen den Eingangsanschlüssen des Verstärkers 50 von diesem verstärkt und von dem Analog-Digital-Wandler 51 digitalisiert. Somit liegen nacheinander die Nullpunkt-Spannung und die erste Kalibrier-Spannung und die zweite Kalibrier-Spannung als digitalisierte Werte an dem Ausgangsanschluss 52 an. Diese vier Werte werden wie im Folgenden dargestellt weiterverarbeitet. Optional können zur Erhöhung der Messgenauigkeit weitere Durchläufe dieser Kalibriermessung durchgeführt werden.

Insbesondere im Fall einer laufenden Messung, d.h. wenn die Kalibrierung während eines Anschlusses eines Messsignals an dem Eingangsanschluss 10 durchgeführt wird, ist es sinnvoll, die Kalibrierung während eines längeren Zeitraums durchzuführen und so eine Vielzahl von Nullpunkt-Spannungen und Kalibrier-Spannungen bei beiden Polungen aufzuzeichnen. Erst wenn das Messsignal die oben genannten Bedingungen erfüllt, können die im Rahmen der Kalibrier-Messungen gewonnen Daten genutzt werden.

Die Spannungsquellen 42, 43 erzeugen dabei eine betragsmäßig identische Konstantspannung, welche sich jedoch wie dargestellt in ihrer Polung unterscheidet.

Die Schalter 34, 35 der Kalibrier-Einrichtung 5 werden dabei bevorzugt als Halbleiterschalter realisiert. Vorteilhaft an der Ausgestaltung als Umschalter ist, dass im normalen Messbetrieb und während der Nullpunktmessungen Leckströme der Schalter definiert an die Masseanschlüsse 40, 41 abfließen. Alternativ können natürlich lediglich Öffner eingesetzt werden, welche den Anschluss zu den Spannungsquellen 42, 43 herstellen, oder nicht.

Verbunden mit der Ausführung als Umschalter ist der Umstand, dass die beiden Innenwiderstände 30, 31 im Messbetrieb die Detektor-Ausgangsspannung an den Eingangsanschlüssen des Verstärkers 50 belasten. Ist jedoch der Wert der Innenwiderstände 30, 31 ausreichend hoch dimensioniert, ist dies tolerabel. Die Abweichungen lassen sich außerdem rechnerisch kompensieren. Zur Realisierung der Spannungsquellen 42, 43 kann mit zweipoligen Shunt-Referenzen z. B. vom Typ LM4040 gearbeitet werden. Ein praktischer Wert für die Konstant-Spannung ist dann z. B. $V_{REF}$ = 2,5 V.

Um eine einfache Auswertung der im Rahmen der Kalibrierung gemessenen Spannung zu erreichen, wird ein Nullabgleich durchgeführt. D.h. die Nullpunkt-Spannung wird von den Kalibrier-Spannungen subtrahiert. Wie zuvor beschrieben, wird der Abgleich für beide Schalterstellungen der Chopper-Einrichtung 28 durchgeführt. Für die folgenden Ausführungen wird davon ausgegangen, dass die gemessenen Kalibrier-Spannungen bereits Nullpunkt-korrigiert sind.

Die erste Kalibrier-Messung entspricht somit einem Punkt $I_{TEST,1}$ -$V_{TEST,1}$ . Die Minuszeichen sollen dabei andeuten, dass beide Dioden bei dieser Messung in Sperrrichtung gepolt sind. Dabei sind die Schalter 34, 35 wie in Fig. 2b gezeigt, angeordnet. Der Konstantstrom wird in Sperrrichtung durch die Detektordioden 14, 15 geleitet und die abfallende erste Kalibrier-Spannung -$V_{TEST,1}$ wird gemessen. Anschließend wird ein weiterer Messpunkt $I_{TEST,2}$, $V_{TEST,2}$ gemessen. Hier sind die Schalter 34, 35 ebenfalls in der in Fig. 2b dargestellten Position. Die Chopper-Einrichtung 28 ist dabei in der in Fig. 2c dargestellten Position. Dadurch wird der konstante Kalibrier-Strom in Durchlassrichtung durch die Dioden geleitet. Wiederum wird die abfallende Spannung mittels des Verstärkers 50 und des Analog-Digital-Wandlers 51 gemessen.

Im Folgenden wird von einer Diodengleichung

$$ I_F = I_S \cdot \left[ \exp\left( \frac{V_F}{m \cdot n \cdot V_T} \right) - 1 \right] \qquad (1) $$

ausgegangen.

Dabei bezeichnet $I_F$ den Strom in Flussrichtung, $I_S$ den Sperrsättigungsstrom der Dioden, $V_F$ die über den Dioden in Flussrichtung anliegende Spannung, m die Anzahl gleichartiger in Reihe geschalteter Dioden, n den Idealitätsfaktor der Dioden und $V_T$ die Temperaturspannung einer einzelnen Diode. Die Gleichung (1) gilt sowohl für Ströme in Flussrichtung als auch in Sperrrichtung. Gemeint ist hier: Wenn die Zählpfeile für Spannung und Strom in Flussrichtung definiert werden, dann gilt für Diodenspannung und Diodenstrom diese Gleichung.

Diese Gleichung wird nach der an den Dioden in Flussrichtung anliegenden Spannung umgestellt:

$$ V_F = m \cdot n \cdot V_T \cdot In\left( \frac{I_F}{I_S} + 1 \right) \qquad (2). $$

Dieser Ausdruck kann nun als Taylorreihe dargestellt werden. Für kleine Aussteuerung, was für den Betrieb des Detektors im quadratischen Bereich zutrifft, kann man weiterhin die Reihenentwicklung nach dem quadratischen Glied abbrechen und erhält die quadratische Näherung

$$ V_F = \frac{I_F \cdot m \cdot n \cdot V_T}{I_S} - \frac{I_F^2 \cdot m \cdot n \cdot V_T}{2 \cdot I_S^2} \qquad (3). $$

Um die Messpunkte zu diesem Modell in Beziehung zu setzen, wird als Ansatz das quadratische Gleichungssystem

$$ -V_{TEST,1} = -I_{TEST,1} \cdot c_1 + I_{TEST,1}^2 \cdot c_2 $$

$$ V_{TEST,2} = I_{TEST,2} \cdot c_1 + I_{TEST,2}^2 \cdot c_2 \qquad (4) $$

aufgestellt. Es existiert eine exakte Lösung, die allerdings etwas unübersichtlich ist. Deshalb wird im Interesse einer übersichtlichen Rechnung wie folgt vorgegangen:

$$ I_{TEST,1} = I_{TEST,2} = I_{TEST}, \qquad (5) $$

d.h. die kleine Änderung des Teststroms zwischen der Messung im Sperrbereich und der Messung im Durchlassbereich wird vernachlässigt. Es wird angenommen, der Teststrom sei über ideale Stromquellen eingespeist. Die Vereinfachung von Gleichung (4) lautet damit

$$ -V_{TEST,1} = -I_{TEST} \cdot c_1 + I_{TEST}^2 \cdot c_2 $$

$$ V_{TEST,2} = I_{TEST} \cdot c_1 + I_{TEST}^2 \cdot c_2 \qquad (6) $$

und die Lösung des Gleichungssystems lautet

$$c_1 = \frac{V_{TEST,1} + V_{TEST,2}}{2 \cdot I_{TEST}} \quad \text{und} \quad c_2 = -\frac{V_{TEST,1} - V_{TEST,2}}{2 \cdot I_{TEST}^2} \tag{7}.$$

Mit der Substitution

$$\frac{V_{TEST,1} + V_{TEST,2}}{2} = V_0 \quad \text{und} \quad \frac{V_{TEST,1} - V_{TEST,2}}{2} = \Delta V \tag{8}$$

folgt:

$$c_1 = \frac{V_0}{I_{TEST}} \quad \text{und} \quad c_2 = -\frac{\Delta V}{I_{TEST}^2} \tag{9}.$$

Nun wird ein Koeffizientenvergleich zwischen Gl. (3) und einem quadratischen Ansatz mit den ermittelten Koeffizienten $C_1$ und $C_2$ durchgeführt:

$$\underbrace{\frac{m \cdot n \cdot V_T}{I_S} \cdot I_F - \frac{m \cdot n \cdot V_T}{2 \cdot I_S^2} \cdot I_F^2}_{Modell} = \underbrace{\frac{V_0}{I_{TEST}} \cdot I_F - \frac{\Delta V}{I_{TEST}^2} \cdot I_F^2}_{Messung} \tag{10}$$

Linearer Koeffizient:

$$\frac{m \cdot n \cdot V_T}{I_S} = \frac{V_0}{I_{TEST}} \rightarrow I_S = \frac{m \cdot n \cdot V_T \cdot I_{TEST}}{V_0} \tag{11}$$

Quadratischer Koeffizient:

$$-\frac{m \cdot n \cdot V_T}{2 \cdot I_S^2} = -\frac{\Delta V}{I_{TEST}^2} \tag{12}$$

$I_S$ wird durch Einsetzen von Gl. (11) in Gl. (12) eliminiert. Nach Vereinfachen folgt:

$$n = \frac{V_0^2}{2 \cdot m \cdot V_T \cdot \Delta V} \tag{13}.$$

Es ist bekannt, dass zwischen Eingangs- und Ausgangsspannung eines unbelasteten Einweg-Diodendetektors mit m in Reihe geschalteten Dioden, der im quadratischen Bereich betrieben wird, der Zusammenhang

$$V_{OUT} = \frac{V_{IN,EFF}^2}{2 \cdot m \cdot n \cdot V_T} \tag{14}$$

besteht. Nach n aufgelöst erhält man

$$n = \frac{V_{IN,EFF}^2}{2 \cdot m \cdot V_T \cdot V_{OUT}} \tag{15}$$

Wenn man in Gleichung (13) den Spannungsmittelwert $V_0$ als Effektivwert $V_{IN,EFF}$ einer fiktiven Eingangsspannung und die Spannungsdifferenz $\Delta V$ als resultierende Ausgangsspannung des Detektors betrachtet, beschreiben die beiden Gleichungen (13) und (15) denselben Sachverhalt.

Damit ist bewiesen, dass der in dieser Patentanmeldung vorgestellte Gleichstromtest es erlaubt, die Gleichrichtwirkung des Detektors für Wechselspannungen zu bestimmen.

Wie Gleichung (15) zeigt, hängt die Gleichrichtwirkung eines gegebenen Detektors bei einer bestimmten Temperatur T nur vom Idealitätsfaktor n ab, wenn man die Temperaturspannung $V_T$ als gegeben ansieht. Die Temperaturspannung $V_T$ ist aber selbst auch etwas temperaturabhängig, es gilt

$$V_T = \frac{k \cdot T}{e} \qquad (15),$$

was einem Temperaturkoeffizienten des Detektors von etwa -0,3 % / K entspricht. Dabei ist k die Boltzmannkonstante, e die Elementarladung und T die Temperatur in Kelvin. Die Temperatur muss also stets mitgemessen werden, wenn Rückschlüsse auf die Stabilität des Detektors bei unterschiedlichen Kalibriertemperaturen getroffen werden sollen.

Der Idealitätsfaktor n ist ebenfalls etwas temperaturabhängig, was bei sehr hohen Anforderungen an die Genauigkeit der Kalibrierung berücksichtigt werden muss, allerdings nur dann, wenn unterschiedliche Kalibriertemperaturen zugelassen werden sollen. Man benötigt also ein Modell für die Temperaturabhängigkeit des Idealitätsfaktors, um zwei bei unterschiedlichen Temperaturen gemessene Idealitätsfaktoren miteinander vergleichen zu können. Dieses Modell für die Temperaturabhängigkeit von n wird für einen gewöhnlichen Messbetrieb aber ohnehin benötigt, wenn man den Einfluss der Umgebungstemperatur vollständig aus dem Messergebnis eliminieren will. Deswegen entsteht dadurch in der Regel kein Mehraufwand.

Das Modell für die Temperaturabhängigkeit von n kann auch dazu benutzt werden, um n für eine fest vorgegebene Referenztemperatur $T_{ref}$, typischerweise 300 K, zu definieren, um Vergleiche erst nach Reduktion von n auf diese Referenztemperatur durchzuführen. Bei der ersten internen Kalibrierung entsprechend dieser Erfindung, die im Herstellerwerk vorgenommen werden dürfte, würde man also zunächst den Idealitätsfaktor n nach Gleichung 13 berechnen, wobei $V_T$ für die ebenfalls ermittelte Temperatur T berechnet würde. Mit dem mathematischen Modell für die Temperaturabhängigkeit von n würde daraus in einem zweiten Schritt der Idealitätsfaktor $n_{REF}$ für die Referenztemperatur $T_{REF}$ berechnet und in einem Kalibrierdatensatz des Messkopfes abgelegt. Bei der späteren Durchführung einer internen Kalibrierung würde zunächst wieder der Idealitätsfaktor n' ermittelt, der im zweiten Schritt ebenfalls auf die Referenztemperatur normiert würde. Der erhaltene reduzierte Wert $n'_{REF}$ würde nun mit dem gespeicherten Wert $n_{REF}$ verglichen. Liegt die Abweichung außerhalb eines vorgegebenen Toleranzbereiches, muss eine Beschädigung des Detektors angenommen werden.

Die gezeigte Schaltung ist ebenfalls geeignet, um den Nullpunktwiderstand der Dioden zu bestimmen. Der Nullpunktwiderstand ist der lineare Koeffizient $c_1$ aus Gl. (7).

Abschließend wird die exakte Gleichung für den Gleichrichtwert ohne die Näherung aus Gl. (5) angegeben:

$$n = \frac{1}{2 \cdot m \cdot V_T} \cdot \frac{\left(V_{TEST,1} + V_{TEST,2}\right)^2 \cdot \left(V_{TEST,1} \cdot V_{TEST,2} + 4 \cdot V_{REF}^2\right)^2}{\left[V_{TEST,1} \cdot V_{TEST,2} + V_{REF}\left(V_{TEST,1} - V_{TEST,2}\right)\right] \cdot \left(V_{TEST,1} - 2 \cdot V_{REF}\right) \cdot \left(V_{TEST,2} + 2 \cdot V_{REF}\right) \cdot \left(V_{TEST,1} - V_{TEST,2} - 4 \cdot V_{REF}\right)}$$

$$(16).$$

Dieser Ausdruck ist nicht vergleichbar anschaulich wie der Ausdruck aus Gleichung (13), ist jedoch allgemein gültig und numerisch selbst auf einem leistungsschwachen Rechner problemlos handhabbar.

Die Erfindung ist nicht auf das dargestellte Ausführungsbeispiel beschränkt. Insbesondere dürfen die Polaritäten der Stromquellen 46 und 47 vertauscht werden, d.h. wenn der Schalter 26 in die Stellung 24 gebracht würde, flösse der Strom in Flussrichtung durch die Dioden (im ausgeführten Beispiel ist es gerade umgekehrt).Alle vorstehend beschriebenen Merkmale oder in den Figuren gezeigten Merkmale sind im Rahmen der Erfindung beliebig vorteilhaft miteinander kombinierbar.

**Patentansprüche**

**1.** Messgerät zur Messung einer Leistung eines Messsignals mit einer Analog-Verarbeitungseinrichtung (1) und einer Kalibrier-Einrichtung (5) zur Durchführung eines Kalibriervorgangs,
wobei die Analog-Verarbeitungseinrichtung (1) zwei gegenüber einem Signaleingang (10) antiparallel geschaltete Detektordioden (14, 15) und einen Verstärker (50) zur Verstärkung von Signalen, welche von Ausgangssignalen der Detektordioden (14, 15) abgeleitet sind, aufweist,
wobei die Analog-Verarbeitungseinrichtung (1) weiterhin eine Chopper-Einrichtung (28) aufweist, welche eingangsseitig an zwei Anschlüssen mit jeweils einem dem Signaleingang abgewandten Anschluss der beiden Detektordioden (14, 15) und ausgangsseitig an zwei Anschlüssen mit jeweils einem Eingang des Verstärkers (50) verbunden ist,
**dadurch gekennzeichnet,**
**dass** die Kalibrier-Einrichtung (5) zur Messung einer Kalibrierspannung derart gestaltet ist, dass sie durch die Analog-Verarbeitungseinheit (1) einen Kalibrierstrom treibt und hierzu zumindest eine Stromquelle (46, 47) aufweist, wobei die zumindest eine Stromquelle (46, 47) mit zumindest einem Eingangsanschluss des Verstärkers (50) verbunden ist, so dass der Kalibrierstrom entweder durch beide Detektordioden in Flussrichtung fließt oder der Kalibrierstrom durch beide Detektordioden in Sperrrichtung fließt.

2. Messgerät nach Anspruch 1,
**dadurch gekennzeichnet,**
**dass** die zumindest eine Stromquelle (46, 47) ausgebildet ist, um einen Kalibrier-Strom durch die Chopper-Einrichtung (28) und die Detektordioden (14, 15) zu treiben,
**dass** der Verstärker (50) ausgebildet ist um eine resultierende Kalibrier-Spannung zu verstärken, und
**dass** das Messgerät (6) ausgebildet ist, um die verstärkte Kalibrier-Spannung zu messen.

3. Messgerät nach Anspruch 2,
**dadurch gekennzeichnet,**
**dass** die Chopper-Einrichtung (28) ausgebildet ist, um eine Flussrichtung des Kalibrier-Stroms durch die Detektordioden (14, 15) umzupolen,
**dass** der Verstärker (50) ausgebildet ist um resultierende Kalibrier-Spannungen zu verstärken, und
**dass** das Messgerät (6) ausgebildet ist, um die verstärkten Kalibrier-Spannungen zu messen.

4. Messgerät nach einem der Ansprüche 1 bis 3,
**dadurch gekennzeichnet,**
**dass** an dem Verstärker (50) eine Nullpunkt-Spannung anliegt, wenn kein Strom von der zumindest einen Stromquelle (46, 47) erzeugt wird,
**dass** der Verstärker (50) ausgebildet ist, um die Nullpunkt-Spannung zu verstärken, und
**dass** das Messgerät (6) ausgebildet ist, um die verstärkte Nullpunkt-Spannung zu messen.

5. Messgerät nach einem der Ansprüche 1 bis 4,
**dadurch gekennzeichnet,**
**dass** die zumindest eine Stromquelle (46, 47) eine Spannungsquelle (42, 43) und einen Innenwiderstand (30, 31) aufweist.

6. Messgerät nach Anspruch 5,
**dadurch gekennzeichnet,**
**dass** der zumindest eine Innenwiderstand (30, 31) größer als ein Ausgangswiderstand der Detektordioden (14, 15), bevorzugt zumindest 5mal größer, besonders bevorzugt zumindest 10 mal größer ist.

7. Messgerät nach Anspruch 6,
**dadurch gekennzeichnet,**
**dass** die zumindest eine Stromquelle (46, 47) einen Schalter (34, 35) aufweist, welcher ausgebildet ist, um den zumindest einen Innenwiderstand (30, 31) von der zumindest einen Spannungsquelle (42, 43) zu trennen und mit zumindest einem Masseanschluss (40, 41) zu verbinden.

8. Messgerät nach einem der Ansprüche 1 bis 7,
**dadurch gekennzeichnet,**
**dass** das Messgerät (6) weiterhin eine Steuereinrichtung (4) aufweist, welche ausgebildet ist,
um die Analog-Verarbeitungseinrichtung (1) und die Kalibrier-Einrichtung (5) zu steuern, und
um Messergebnisse eines Kalibriervorgangs zu verarbeiten.

9. Messgerät nach Anspruch 8,

**dadurch gekennzeichnet,**
**dass** die Steuereinrichtung (4) ausgebildet ist, um ein Umschalten der Chopper-Einrichtung (28) und ein Umschalten sämtlicher Schalter (34, 35) der Kalibrier-Einrichtung (5) zu steuern.

**10.** Messgerät nach Anspruch 8 oder 9,
**dadurch gekennzeichnet,**
**dass** die Kalibrier-Einrichtung (5) ausgebildet ist, um den Kalibriervorgang durchzuführen, während ein Messsignal anliegt und
**dass** die Steuereinrichtung (4) ausgebildet ist, um Messergebnisse des Kalibriervorgangs lediglich dann zu berücksichtigen, wenn das Messsignal vorbestimmten Bedingungen genügt.

**11.** Messgerät nach Anspruch 10,
**dadurch gekennzeichnet,**
**dass** die Steuereinrichtung (4) ausgebildet ist, um Messergebnisse des Kalibriervorgangs lediglich dann zu berücksichtigen, wenn

- ein Messsignal eine derartige Leistung aufweist, dass die Detektordioden (14, 15) in einem quadratischen Kennlinienbereich betrieben sind, und/oder
- ein Messsignal über einen vorbestimmten Zeitraum konstant ist.

**12.** Messgerät nach Anspruch 9,
**dadurch gekennzeichnet,**
**dass** die Kalibrier-Einrichtung (5) ausgebildet ist, um den Kalibriervorgang lediglich durchzuführen, wenn kein Messsignal anliegt.

**13.** Messgerät nach einem der Ansprüche 1 bis 12,
**dadurch gekennzeichnet,**
**dass** der Verstärker (50) derart beschaltet ist, dass er an seinen beiden Eingängen hochohmig betrieben ist.

**14.** Messgerät nach einem der Ansprüche 1 bis 13,
**dadurch gekennzeichnet,**
**dass** die Analog-Verarbeitungseinrichtung (1) zumindest weitgehend symmetrisch aufgebaut ist, und/oder dass die Kalibrier-Einrichtung (5) zumindest weitgehend symmetrisch aufgebaut ist.

**15.** Messgerät nach Anspruch 14,
**dadurch gekennzeichnet,**
**dass** die Kalibrier-Einrichtung (5) zwei Stromquellen (46, 47) aufweist,
**dass** die zwei Stromquellen (46, 47) jeweils über eine Spannungsquelle (42, 43) und einen Innenwiderstand (30, 31) verfügen,
**dass** die zwei Stromquellen (46, 47) gegensinnig gepolt sind, und
**dass** die zwei Stromquellen (46, 47) mit den beiden Anschlüssen des Verstärkers (50) verbunden sind.

**16.** Messgerät nach einem der Ansprüche 1 bis 15,
**dadurch gekennzeichnet,**
**dass** das Messgerät (6) weiterhin eine Temperatur-Messeinrichtung beinhaltet, welches ausgebildet ist, um bei der Durchführung des Kalibriervorgangs eine gegenwärtige Temperatur zu messen, und
**dass** das Messgerät (6) ausgebildet ist, um die gemessene gegenwärtige Temperatur zu einer Temperaturkompensation des Kalibriervorgangs heranzuziehen.

**Claims**

**1.** Measuring instrument for measuring a power of a measurement signal with an analogue processing device (1) and a calibrating device (5) for carrying out a calibrating operation,
wherein the analogue processing device (1) comprises two detector diodes (14, 15) connected antiparallel with a signal input (10), and an amplifier (50) for amplifying signals which are derived from output signals of the detector diodes (14, 15), wherein the analogue processing device (1) also comprises a chopper device (28) which is connected on the input side to two connections each with a connection of the two detector diodes (14, 15) remote from the signal input, and on the output side to two connections each with an input of the amplifier (50),
**characterised in that**
the calibrating device (5) for measuring a calibrating voltage is configured such that it drives a calibrating current through the analogue processing unit (1) and for this comprises at least one current source (46, 47), wherein the at least one current source (46, 47) is connected with at least one input connection of the amplifier (50) so that either the calibrating current flows through the two detector diodes in the forward direction or the calibrating current flows through the two detector diodes in the backward direction.

2. Measuring instrument according to claim 1,
**characterised in that**
the at least one current source (46, 47) is configured to drive a calibrating current through the chopper device (28) and the detector diodes (14, 15),
**in that** the amplifier (50) is configured to amplify a resulting calibrating voltage, and **in that** the measuring instrument (6) is configured to measure the amplified calibrating voltage.

3. Measuring instrument according to claim 2,
**characterised in that**
the chopper device (28) is configured to reverse the forward direction of flow of the calibrating current through the detector diodes (14, 15),
**in that** the amplifier (50) is configured to amplify resulting calibrating voltages, and **in that** the measuring instrument (6) is configured to measure the amplified calibrating voltages.

4. Measuring instrument according to one of claims 1 to 3,
**characterised in that**
a neutral-to-ground voltage is applied at the amplifier (50) when no current is produced by the at least one current source (46, 47),
**in that** the amplifier (50) is configured to amplify the neutral-to-ground voltage, and **in that** the measuring instrument (6) is configured to measure the amplified neutral-to-ground voltage.

5. Measuring instrument according to one of claims 1 to 4,
**characterised in that**
the at least one current source (46, 47) comprises a voltage source (42, 43) and an internal resistance (30, 31).

6. Measuring instrument according to claim 5,
**characterised in that**
the at least one internal resistance (30, 31) is greater than an output resistance of the detector diodes (14, 15), preferably at least 5 times greater, particularly preferably at least 10 times greater.

7. Measuring instrument according to claim 6,
**characterised in that**
the at least one current source (46, 47) comprises a switch (34, 35) which is configured to disconnect the at least one internal resistance (30, 31) from the at least one voltage source (42, 43) and to connect it with at least one ground connection (40, 41).

8. Measuring instrument according to one of claims 1 to 7,
**characterised in that**
the measuring instrument (6) also comprises a control device (4) which is configured to control the analogue processing device (1) and the calibrating device (5), and
to process measurement results of a calibrating operation.

9. Measuring instrument according to claim 8,
**characterised in that**
the control device (4) is configured to control switchover of the chopper device (28) and switchover of all the switches (34, 35) of the calibrating device (5).

10. Measuring instrument according to claim 8 or 9,
**characterised in that**
the calibrating device (5) is configured to carry out the calibrating operation while a measurement signal is applied, and

**in that** the control device (4) is configured to take account of measurement results of the calibrating operation only when the measurement signal satisfies predetermined conditions.

11. Measuring instrument according to claim 10,
    **characterised in that**
    the control device (4) is configured to take account of measurements results of the calibrating operation only when

    - a measurement signal has such a power that the detector diodes (14, 15) are operated in a quadratic characteristic range, and/or
    - a measurement signal is constant over a predetermined period of time.

12. Measuring instrument according to claim 9,
    **characterised in that**
    the calibrating device (5) is configured to carry out the calibrating operation only when no measurement signal is applied.

13. Measuring instrument according to one of claims 1 to 12,
    **characterised in that**
    the amplifier (50) is wired so that it is operated with a high ohmic resistance at both its inputs.

14. Measuring instrument according to one of claims 1 to 13,
    **characterised in that**
    the analogue processing device (1) is of at least largely symmetrical construction, and/or
    **in that** the calibrating device (5) is of at least largely symmetrical construction.

15. Measuring instrument according to claim 14,
    **characterised in that**
    the calibrating device (5) comprises two current sources (46, 47),
    **in that** the two current sources (46, 47) each have a voltage source (42, 43) and an internal resistance (30, 31),
    **in that** the two current sources (46, 47) are polarised in opposite directions, and
    **in that** the two current sources (46, 47) are connected with the two connections of the amplifier (50).

16. Measuring instrument according to one of claims 1 to 15,
    **characterised in that**
    the measuring instrument (6) also comprises a temperature measuring device which is configured to measure a present temperature when the calibrating operation is carried out, and
    **in that** the measuring instrument (6) is configured to use the measured present temperature for temperature-compensation for the calibrating operation.

**Revendications**

1. Appareil de mesure destiné à mesurer une puissance d'un signal de mesure comprenant un dispositif de traitement analogique (1) et un dispositif d'étalonnage (5) pour effectuer une opération d'étalonnage, appareil de mesure dans lequel le dispositif de traitement analogique (1) comprend deux diodes de détection (14, 15) agencées selon un montage antiparallèle par rapport à une entrée de signal (10), et un amplificateur (50) pour amplifier des signaux qui sont dérivés de signaux de sortie des diodes de détection (14, 15),
dans lequel le dispositif de traitement analogique (1) comprend en outre un dispositif hacheur (28), qui est relié, du côté entrée au niveau de deux bornes de connexion, à respectivement une borne de connexion opposée à l'entrée de signal des deux diodes de détection (14, 15), et du côté sortie au niveau de deux bornes de connexion, à respectivement une entrée de l'amplificateur (50),
**caractérisé**
**en ce que** le dispositif d'étalonnage (5), pour mesurer une tension d'étalonnage, est configuré de manière à exciter un courant d'étalonnage à travers le dispositif de traitement analogique (1) et présente à cet effet au moins une source de courant (46, 47), ladite au moins une source de courant (46, 47) étant reliée à au moins une borne d'entrée de l'amplificateur (50), de sorte que le courant d'étalonnage circule à travers les deux diodes de détection dans le sens passant ou bien le courant d'étalonnage circule à travers les deux diodes de détection dans le sens bloquant.

**2.** Appareil de mesure selon la revendication 1,
**caractérisé**

**en ce que** ladite au moins une source de courant (46, 47) est configurée pour exciter un courant d'étalonnage à travers le dispositif hacheur (28) et les diodes de détection (14, 15),

**en ce que** l'amplificateur (50) est configuré pour amplifier une tension d'étalonnage résultante, et

**en ce que** l'appareil de mesure (6) est configuré pour mesurer la tension d'étalonnage amplifiée.

**3.** Appareil de mesure selon la revendication 2,
**caractérisé**

**en ce que** le dispositif hacheur (28) est configuré pour inverser un sens de circulation du courant d'étalonnage à travers les diodes de détection (14, 15),

**en ce que** l'amplificateur (50) est configuré pour amplifier des tensions d'étalonnage résultantes, et

**en ce que** l'appareil de mesure (6) est configuré pour mesurer les tensions d'étalonnage amplifiées.

**4.** Appareil de mesure selon l'une des revendications 1 à 3,
**caractérisé**

**en ce qu'**à l'amplificateur (50) est appliquée une tension de point zéro lorsqu'aucun courant n'est produit par ladite au moins une source de courant (46, 47),

**en ce que** l'amplificateur (50) est configuré pour amplifier la tension de point zéro, et

**en ce que** l'appareil de mesure (6) est configuré pour mesurer la tension de point zéro amplifiée.

**5.** Appareil de mesure selon l'une des revendications 1 à 4,
**caractérisé**

**en ce que** ladite au moins une source de courant (46, 47) comprend une source de tension (42, 43) et une résistance interne (30, 31).

**6.** Appareil de mesure selon la revendication 5,
**caractérisé**

**en ce que** ladite au moins une résistance interne (30, 31) est plus grande qu'une résistance de sortie des diodes de détection (14, 15), de préférence au moins 5 fois plus grande, et de manière particulièrement préférée au moins 10 fois plus grande.

**7.** Appareil de mesure selon la revendication 6,
**caractérisé**

**en ce que** ladite au moins une source de courant (46, 47) comporte un commutateur (34, 35) configuré pour isoler ladite au moins une résistance interne (30, 31) de ladite au moins une source de tension (42, 43) et la relier à au moins une borne de connexion à la masse (40, 41).

**8.** Appareil de mesure selon l'une des revendications 1 à 7,
**caractérisé**

**en ce que** l'appareil de mesure (6) comporte en outre un dispositif de commande (4), qui, est configuré pour commander le dispositif de traitement analogique (1) et le dispositif d'étalonnage (5), et pour traiter les résultats de mesure d'une opération d'étalonnage.

**9.** Appareil de mesure selon la revendication 8,
**caractérisé**

**en ce que** le dispositif de commande (4) est configuré pour commander une commutation d'inversion du dispositif hacheur (28) et une commutation d'inversion de l'ensemble des commutateurs (34, 35) du dispositif d'étalonnage (5).

**10.** Appareil de mesure selon la revendication 8 ou la revendication 9,
**caractérisé**

**en ce que** le dispositif d'étalonnage (5) est configuré pour effectuer l'opération d'étalonnage pendant qu'est appliqué un signal de mesure, et

**en ce que** le dispositif de commande (4) est configuré pour prendre en considération des résultats de mesure de l'opération d'étalonnage uniquement lorsque le signal de mesure satisfait à des conditions prédéterminées.

**11.** Appareil de mesure selon la revendication 10,
**caractérisé**

**en ce que** le dispositif de commande (4) est configuré pour prendre en considération des résultats de mesure de l'opération d'étalonnage uniquement lorsque

- un signal de mesure présente une puissance telle, que les diodes de détection (14, 15) fonctionnent dans une plage caractéristique quadratique, et/ou
- un signal de mesure est constant sur un intervalle de temps prédéterminé.

12. Appareil de mesure selon la revendication 9,
    **caractérisé**
    **en ce que** le dispositif d'étalonnage (5) est configuré pour effectuer l'opération d'étalonnage uniquement lorsqu'aucun signal de mesure n'est appliqué.

13. Appareil de mesure selon l'une des revendications 1 à 12,
    **caractérisé**
    **en ce que** l'amplificateur (50) est monté en circuit de manière à ce que ses deux entrées fonctionnent avec une impédance élevée.

14. Appareil de mesure selon l'une des revendications 1 à 13,
    **caractérisé**
    **en ce que** le dispositif de traitement analogique (1) est au moins dans une large mesure d'un mode de construction symétrique, et/ou
    **en ce que** le dispositif d'étalonnage (5) est au moins dans une large mesure d'un mode de construction symétrique.

15. Appareil de mesure selon la revendication 14,
    **caractérisé**
    **en ce que** le dispositif d'étalonnage (5) comprend deux sources de courant (46, 47),
    **en ce que** les deux sources de courant (46, 47) disposent chacune d'une source de tension (42, 43) et d'une résistance interne (30, 31),
    **en ce que** les deux sources de courant (46, 47) sont de polarités inversées, et
    **en ce que** les deux sources de courant (46, 47) sont reliées aux deux bornes de connexion de l'amplificateur (50).

16. Appareil de mesure selon l'une des revendications 1 à 15,
    **caractérisé**
    **en ce que** l'appareil de mesure (6) renferme en outre un dispositif de mesure de température, qui est configuré pour mesurer une température actuelle lors de l'exécution d'une opération d'étalonnage, et
    **en ce que** l'appareil de mesure (6) est configuré pour prendre en considération la température actuelle mesurée en vue d'une compensation en température de l'opération d'étalonnage.

**Fig. 1**

Fig. 2a

Fig. 2b

Fig. 2c

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1443335 A1
- DE 102006024699 A1
- EP 1043595 A1